# EUROPEAN PATENT SPECIFICATION

(11) **EP 1 724 825 B1**
(45) Date of publication and mention of the grant of the patent: **10.12.2008**
(21) Application number: 06252440.0
(22) Date of filing: 09.05.2006
(51) Int. Cl.: H01L 21/687, H01L 21/677, B65D 85/30

(54) **Substrate storage container and method for manufacturing the same**
Ein Substratlagerbehälter und ein Verfahren zur dessen Herstellung
Un conteneur de stockage pour de substrats et un procédé de fabraction de ce conteneur de stockage

(30) Priority: 17.05.2005 JP 2005144137
(43) Date of publication of application: 22.11.2006
(73) Proprietor: SHIN-ETSU POLYMER CO., LTD., Tokyo 103-0023 (JP)
(72) Inventor: Hasegawa, Akihiro, c/o Niigata Polymer Co., Ltd., Itoigawa, Niigata 941-0007 (JP); Mimura, Hiroshi, c/o Niigata Polymer Co., Ltd., Itoigawa, Niigata 941-0007 (JP)
(74) Representative: Cheyne, John Robert Alexander M.

(56) References cited:
- EP-A- 0 436 030
- EP-A- 1 605 496
- US-A- 5 584 401
- PATENT ABSTRACTS OF JAPAN vol. 2003, no. 04, 2 April 2003 (2003-04-02) -& JP 2002 347061 A (SHIN ETSU POLYMER CO LTD), 4 December 2002 (2002-12-04)
- PATENT ABSTRACTS OF JAPAN vol. 1999, no. 08, 30 June 1999 (1999-06-30) -& JP 11 059779 A (KAWASAKI STEEL CORP), 2 March 1999 (1999-03-02)

## Description

### BACKGROUND OF THE INVENTION

### Field of the Invention

The present invention relates to a substrate storage container for storing various types of semiconductor wafers or substrates made of a photo-mask glass, a aluminum disc or the like.

### Related Background of Art

A conventional substrate storage containers, which is not shown in the drawings, includes a container main body in which a plurality of substrates including semiconductor wafers are arranged and stored, a lid member which can be freely attached and detached, and which opens and closes the front surface constituting the opening part of this container main body, and an anchoring mechanism which fastens the lid member that covers the front surface of the container main body. Such containers are utilized as precision substrate storage containers. A plurality of supporting parts are respectively disposed on the inside surfaces of both side walls of the container main body and have a shape bent along a peripheral edge of the substrate in order to horizontally support the side portion of the substrate. A front retainer which retains the peripheral edge of the front part of the substrate is mounted on the inside surface of the lid member.

Such substrate storage containers are used for the safe transport of substrates from substrate production factories to processing factories. At these processing factories, the substrates are subjected to various types of treatments to produce semiconductor parts or parts used for the process of semiconductor parts (see Japanese Patent Application Laid-Open No. Hei. 10-101177 and Japanese Patent Application Laid-Open No. 2004-111830).

JP2002-347061 discloses a holding vessel comprising a main body moulded of a first resin and a plurality of support members, each support member individually moulded of a second resin.

US Patent No 5584401 describes a cassette provided with a plurality of substrate-supporting side boards, each side board comprising a metal core and a plurality of shelf members, each of which is at least partly moulded from a dust-inhibited resin, with the remainder being moulded from an electrically conductive resin.

### SUMMARY OF THE INVENTION

Conventional substrate storage containers are constructed as described above, and are therefore susceptible to shocks during loading and transport by means of truck, air freight, ship or the like. When such containers are subjected to shocks, rubbing between the substrates and supporting parts causes damage to the substrates, and results in the generation of particulates that adhere to the surfaces of the substrates, so that they may cause significant problems such as a drop in the function and yield of products. In particular, as the pitch of electronic circuits of semiconductor parts has become finer in recent years, contamination by particulates has become a serious problem.

Conventionally, furthermore, a region of 3 mm in the inward radial direction from the peripheral edge part of the substrate has been treated as an exclusion region, which is not used in the working of semiconductor parts. In recent years, however, from the standpoint of achieving a finer pitch in electronic circuits and making products more compact, there has been a demand to increase the yield by narrowing the exclusion region. In order to satisfy such a demand, it is necessary to prevent contamination and scratching of the peripheral edge parts and back surface of the substrate.

In view of the above-mentioned facts, an object of the present invention is to provide a substrate storage container which can prevent scratching of the substrates and the generation of dust caused by rubbing between the substrates and the supporting parts, so that contamination and scratching of the peripheral edge parts and back surfaces of the substrates can be suppressed, and another object of the present invention is to provide a method for manufacturing such a substrate storage container.

According to one aspect of the present invention there is provided a substrate storage container comprising:
a container main body made of resin and including an opening portion, a back wall, a pair of side walls and bent rear part inside surfaces respectively between the back wall and one of the side walls;
a lid member closing the opening portion of the container main body; and
first supporting parts protrudingly and opposingly disposed on each side wall configured to support a peripheral edge part of a substrate;
characterised in that
the substrate storage container further comprises:
second supporting parts protrudingly and opposingly disposed on each side wall in order to support the peripheral edge part of the substrate and positioned between the back wall and the first supporting parts,
the first supporting parts, the second supporting parts or the bent rear part inside surfaces are respectively covered with a resin layer having a lower frictional property than that of the container main body, and
wherein each first supporting part includes
a first region supporting the peripheral edge part of the substrate via the resin layer and
a second region formed on an outer side of the first region the first region being thinner than the second region to define bumps, and
wherein each second supporting part includes
a supporting region supporting the peripheral edge of the substrate via the resin layer, the supporting region being thinner than the second region of the first supporting part, and
wherein the first regions of the first supporting parts and the supporting regions of the second supporting parts are disposed in order to support the substrate in a horizontal attitude; and
wherein the side wall of the container main body further comprises a contacting portion in order to contact with the peripheral edge part of the substrate,
wherein the contacting portion is positioned on an extension line of an intersecting center line perpendicular to a center line parallel to a direction of inserting and removing the substrate among the center lines passing on the substrate when the substrate is supported on the first supporting part and the second supporting part, and
wherein the contacting portion is covered with the resin layer.

Further, the substrate storage container may further comprise an elastic retainer supporting the peripheral edge part of the substrate and disposed on the back wall of the container main body.

Further, the first supporting parts and second supporting parts may be respectively protruded from the side walls of the container main body, and a clearance is formed between the first supporting part and the second supporting part on each side wall.

Further, the container main body may be made of a material including one of polycarbonate, polybutylene terephthalate, cycloolefin polymer, polyether imide, polyether ether ketone and alloy resin, and the resin layer may be made of one of polybutylene terephthalate and polyether ether ketone.

Further, the resin layer may include a flange formed inside the side wall and having an outer portion near an outside surface of the side wall and an inner portion near an inside surface of the side wall, and the outer portion may have a larger dimension than that of the inner portion.

According to a second aspect of the present invention there is provided a method for manufacturing a substrate storage container including a container main body made of resin and having an opening portion, a back wall, a pair of side walls and bent rear part inside surfaces respectively between the back wall and one of the side walls, first supporting parts protrudingly and opposingly disposed on each side wall in order to support a peripheral edge part of a substrate, and second supporting parts protrudingly and opposingly disposed on each side wall in order to support the peripheral edge part of the substrate and positioned between the back wall and the first supporting parts, said method comprising:
forming the first supporting parts and the second supporting parts so as to protrude inward from the side walls of the container main body;
covering the first supporting parts, the second supporting parts or the bent rear part inside surfaces with a resin layer having a lower frictional property than that of the container main body; and
covering a contacting portion with the resin layer for contacting with the peripheral edge part of the substrate on the side wall of the container main body; and
forming the container main body by inserting the side walls in a mold for forming the back wall of the container main body,
wherein each first supporting part includes
a first region supporting the peripheral edge part of the substrate via the resin layer and
a second region formed on an outer side of the thin region, the first region being thinner than the second region to define bumps for preventing the substrate from moving, and
wherein each second supporting part includes
a supporting region supporting the peripheral edge of the substrate via the resin layer, the supporting region being thinner than the second region of the first supporting part, and
wherein the first regions of the first supporting parts and the supporting regions of the second supporting parts are disposed in order to support the substrate in a horizontal attitude.

Further, the method may further comprise: forming the side wall with a through hole having a shape corresponding to a flange having an outer portion near an outside surface of the side wall and an inner portion near an inside surface of the side wall wherein the outer portion of the flange has a larger dimension than that of the inner portion; and filling the resin for forming the resin layers from the outsides of the side wall via the through hole.

Further, the substrate storage container of the present invention may comprise: a container main body storing a substrate; a cover opening and closing an opening portion of the container main body; first supporting parts respectively disposed on a pair of side walls forming the container main body and positioned on the side of the opening portion of the container main body in order to support a peripheral edge part of the substrate; and second supporting parts respectively disposed on the pair of side walls forming the container main body and positioned on an inside wall side of the container main body in order to support the peripheral edge part of the substrate, wherein at least the first and second supporting parts among the first supporting parts, second supporting parts and contact parts of the respective side walls that contact the peripheral edge part of the substrate are covered with a resin that has a lower friction property than that of the container main body, and an elastic retainer supporting the peripheral edge part of the substrate is disposed on the cover.

An elastic retainer supporting the peripheral edge part of the substrate can be disposed on the inside wall of the container main body, and at least a substrate supporting portion of the retainer may be covered by a resin layer that has a lower friction property than that of the container main body. A transparent window to ascertain the condition of the substrate can be selectively formed in a roof or a circumferential wall of the container main body.

Further, the first and second supporting parts can be integrally formed, and an intermediate part connecting the first and second supporting parts may be formed with a small thickness so that the intermediate part do not contact with the substrates. Further, in regard to the resin layer having a lower friction property, the measured value of the coefficient of friction with respect to steel as measured in accordance with ASTM D1894 may be than 0.33, preferably 0.20 or less.

In the present invention, at least the first and second supporting parts among the parts that might possibly contact with the substrate are respectively covered by engagement, molding or the like with a friction layer that has a lower friction property than that of the material of the container main body. Accordingly, for example, even if shocks or the like act on the substrate storage container, it is possible to suppress the scratching of the substrates or the generation of dust and adhesion of the dust to the substrate as a result of rubbing between the substrates and the first and second supporting parts.

### BRIEF DESCRIPTION OF THE DRAWINGS

Fig. 1 is an overall perspective explanatory diagram showing the first embodiment of the substrate storage container according to the present invention;

Fig. 2 is a perspective explanatory diagram showing a state in which the lid member is removed from the container main body of the substrate storage container shown in Fig. 1;

Fig. 3 is a sectional plan view showing the first embodiment of the substrate storage container according to the present invention;

Fig. 4 is an explanatory diagram showing the side wall in the first embodiment of the substrate storage container according to the present invention;

Fig. 5 is a plan-view explanatory diagram showing the side walls in the first embodiment of the substrate storage container according to the present invention;

Fig. 6 is a sectional view taken along the line VI-VI in Fig. 5 in the first embodiment of the substrate storage container and method for manufacturing the same according to the present invention;

Fig. 7 is a sectional view taken along the line VII-VII in Fig. 5 in the first embodiment of the substrate storage container and method for manufacturing the same according to the present invention;

Fig. 8 is a sectional view taken along the VIII-VIII in Fig. 5 in the first embodiment of the substrate storage container and method for manufacturing the same according to the present invention;

Fig. 9 is a sectional view taken along the line IX-IX in Fig. 5 in the first embodiment of the substrate storage container and method for manufacturing the same according to the present invention; and

Fig. 10 is a sectional plan view showing a second embodiment of the substrate storage container according to the present invention.

### DESCRIPTION OF THE PREFERRED EMBODIMENTS

Preferred embodiments of the present invention will be described below with reference to the attached figures.

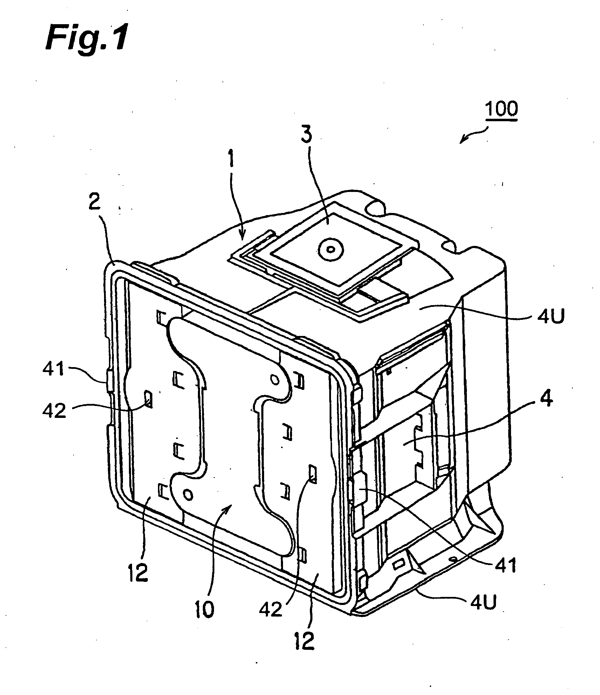

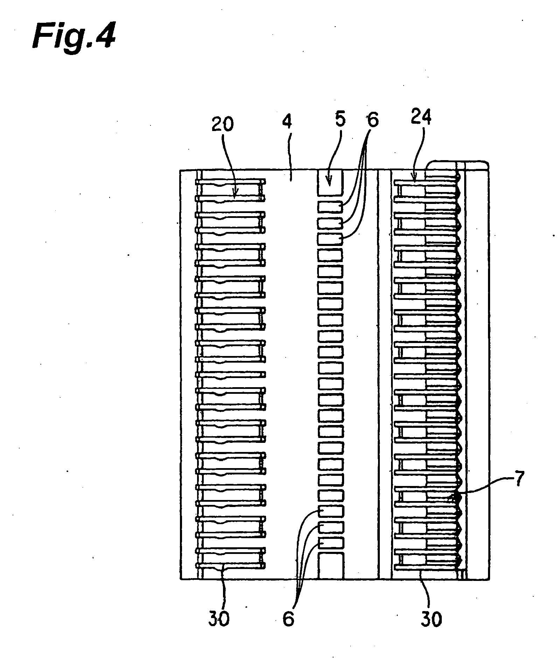

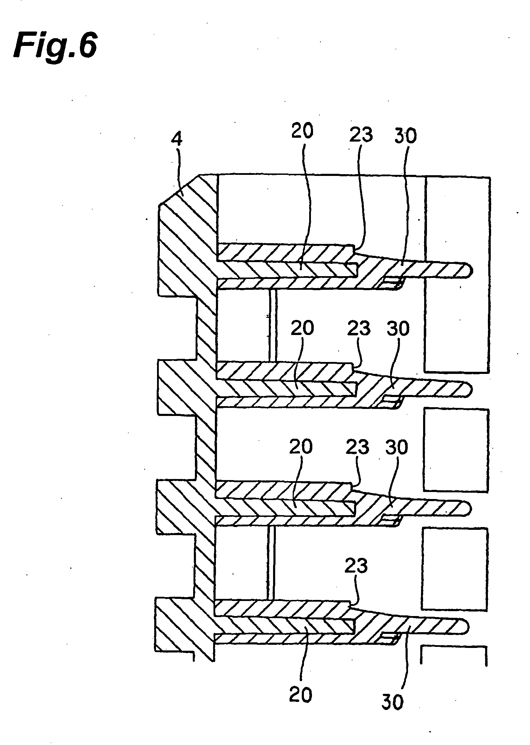

Figs. 1 to 9 show a precision substrate storage container 100 used for shipping according to the first embodiment of the present invention. As shown in Figs. 1 to 9, the substrate storage container 100 comprises a container main body 1, a lid member 10, a plurality of first supporting parts 20, and a plurality of second supporting parts 24.

A container main body 1 includes an opening portion 1F, a back wall 1B opposing the opening portion 1F, and two pairs of side walls 4 and side walls 4U, and the container main body 1 stores a plurality of substrates W between the side walls 4 and side walls 4U. The lid member 10 closes the front side of the container main body 1, which is the opening portion 1F of the container main body 1.

A plurality of first supporting parts 20 are respectively disposed on the pair of left and right side walls 4 forming parts of the container main body 1 and are positioned on the front side of the container main body 1. Specifically, a pair of the first supporting parts 20 are opposingly disposed on each side wall 4 to support a peripheral edge part of substrates W and positioned on the side of the opening portion 1F of the container main body 1.

A plurality of second supporting parts 24 are respectively disposed on the pair of the left and right side walls 4 forming parts of the container main body 1 and are positioned on the rear side of the container main body 1. Specifically, a pair of the second supporting parts 24 are opposingly disposed on each side wall 4 to support the peripheral edge part of substrates W and positioned on the side of the back wall 1B of the container main body 1. In other words, the second supporting parts 24 are positioned between the back wall 1B and the first supporting parts 20.

Contacting portion 5 are formed on the respective side walls 4 in order to contact with the peripheral edge parts of the substrates W so that the substrates W are contacted with the contacting portion 5, for example, when shocks or the like act on the substrate storage container 100. The first and second supporting parts 20 and 24 are covered with a resin layer 30 having a lower frictional property than that of the container main body.

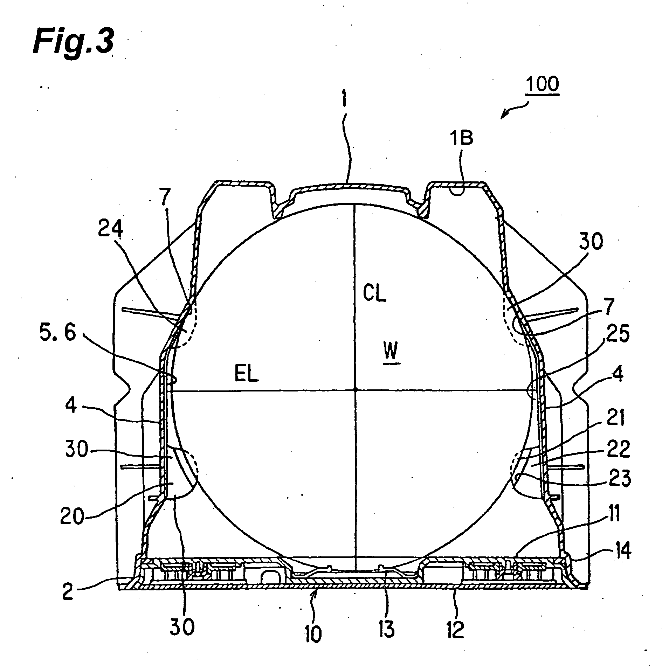

As shown in Fig. 3, the substrates W are thin round semiconductor wafers which have a diameter of, for example, 300 mm. Specifically, the substrates W are made of silicon wafers in which at least one of the front and back surfaces is worked with mirror finish. An orientation flat or a notch with a semi-oval shape as seen in a plan view, both of which are used for alignment, is selectively formed in the circumferential edge part of each wafer, so that the substrates can be inserted and removed by a special robot.

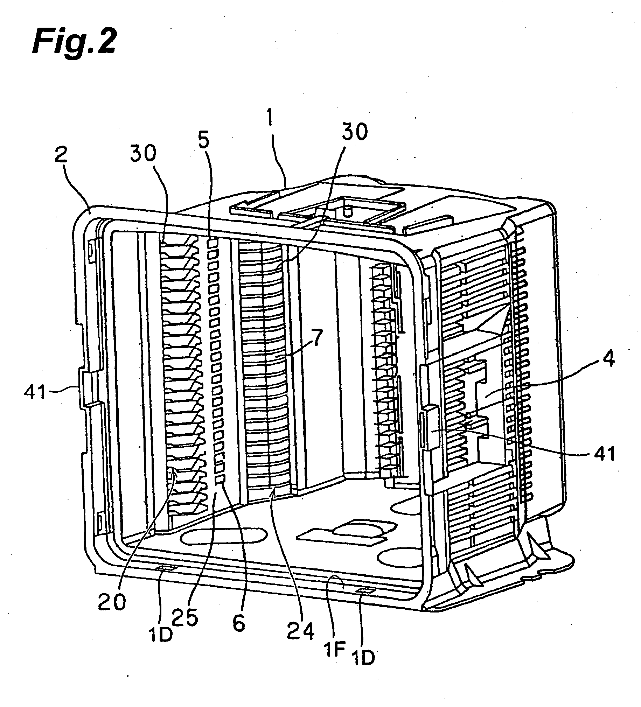

The container main body 1 includes two pairs of recessions 1D opposingly formed in the inner periphery of the opening portion 1F (only the recessions 1D on the lower side are shown in Fig. 2). The lid member 10 includes a locking mechanism (not shown) for fastening the lid member 10 to the container main body 1. The locking mechanism is provided inside the lid member 10 and includes engaging portions which can protrude from the outer periphery of the lid member 10. The lid member 10 is mounted on or dismounted from the container main body 1 by operating the locking mechanism via the through operating holes 42. In addition to this locking mechanism, an anchoring mechanism can be provided on both side portions of the lid member 10 in order to be engaged with anchoring blocks 41 protruding from the front portions of side walls 4 of the container main body 1.

As shown in Figs. 1 through 3, the container main body 1 is formed as a transparent front-open box type container main body by insert molding in which a pair of side walls 4 are inserted into a special mold, and the mold is filled with a predetermined material. The container main body 1 functions so that a plurality of substrates W (for example, 25 or 26 substrates) are lined up and stored at a specified pitch in the vertical direction.

There are no particular restrictions on the material for forming the container main body 1. For example, a resin such as polycarbonate, polybutylene terephthalate, cycloolefm polymer, polyether imide, polyether ether ketone or the like may be selectively used. In addition, a conductive resin produced by adding carbon, carbon fibers, carbon nanotubes, metal fibers, metal oxides, conductive polymers or the like may be added to such resins or alloy resins. Among these materials, polycarbonates, which are superior in terms of transparency, are especially desirable.

In the container main body 1, as shown in Figs. 1 through 3, the circumferential edge part of the front portion is bent outward in substantially an L shape as seen in a sectional view (See Fig. 3), so that a rim part 2 is formed. Positioning fittings used for positioning are disposed on both sides of the front part of the bottom surface and in the center of the rear part of the bottom surface. A robotic flange 3 to be held by an automatic conveying machine is mounted in a detachable manner on the central part of the roof.

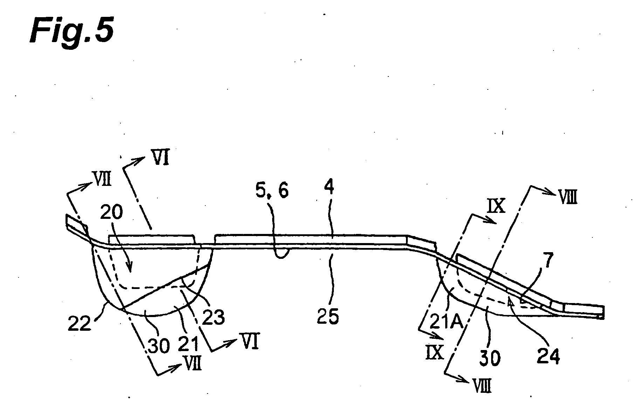

As shown in Figs. 3, 5 and the like, both side walls 4 of the container main body 1 are respectively formed to have a bent shape so as to correspond to the shape of the substrates W, thus forming a plurality of first supporting parts 20 and second supporting parts 24. The first and second supporting parts 20, 24 are formed prior to the manufacture of the container main body 1. Then, after the contacting portion 5 and the first and second supporting parts 20 and 24 that contact the peripheral edge parts of the substrates W are covered by the resin layer 30, a portion of the container main body 1 is formed by inserting the side walls 4 into the mold used for the container main body 1.

As shown in Fig. 3, the lid member 10 comprises a housing body 11 and a cover 12. The housing body 11 is substantially dish-shaped in cross section and is engaged in a detachable manner with the rim part 2 of the front side of the container main body 1. As described above, the locking mechanism for fastening the lid member 10 to the container main body 1 is provided in the lid member 10. The locking mechanism of the lid member 10 engages with and closes off the container main body 1 by means of an operation from the outside. Examples of this kind of locking mechanism are disclosed in United States Patent Application Publication No. 2005/0230398 and United States Patent Application Publication No. 2005/0274645. The cover 12 is mounted on the surface of the housing body 11. An elastic front retainer 13 of the lid member 10 retains the peripheral edges of the front parts of the substrates W and is mounted on the opposite surface of the housing body 11 that faces the inside (that is, the back wall) of the container main body 1. Further, an endless sealing gasket 14 is engaged with the circumferential wall of the housing body 11. The sealing gasket 14 undergoes compressive deformation, and functions to seal the container main body 1.

The lid member 10 is molded with a resin such as a polycarbonate, fluorine-containing polycarbonate, polyether sulfone, polyether imide, polyether ether ketone or the like.

As shown in Figs. 2 through 5, the plurality of first and second supporting parts 20 and 24 protrude separately inward from both side walls (specifically, the inside surfaces of both side walls) of the container main body 1. A clearance 25 is formed between these first and second supporting parts 20 and 24 on each side wall (See Figs. 3 and 5).

As shown in Figs. 3 through 7, the plurality of first supporting parts 20 are arranged in parallel at a specified pitch in the vertical direction on the inside surfaces of the respective side walls 4 forming the container main body 1. Further, the first supporting parts 20 are arranged in a position closer to the front side of the container main body 1, and support the peripheral edges of the side parts of the substrates W in a horizontal attitude via the resin layers 30. Each first supporting part 20 is covered with the resin layer 30 and formed in a substantially semicircular shape as seen in a plan view (See Figs. 3 and 5) to have a thin first region 21 and a thick second region 22. The first region 21 is thinner than the second region 22. The thin region 21 protrudes toward the inside of the container main body 1 from the inside surface of the corresponding side wall 4, and supports the peripheral edge of the side part of the substrate W in a horizontal attitude via the resin layer 30. The thick region 22 is formed on the outer side of the thin region 21 (that is, on the side of the side wall 4), and prevents the substrate W from jumping out or moving. Shoulders or bumps 23 corresponding to the thickness of the substrate W are formed by the thin region 21 and the thick region 22 and shape the thin region 21 into a circular arc shape as seen in a plan view.

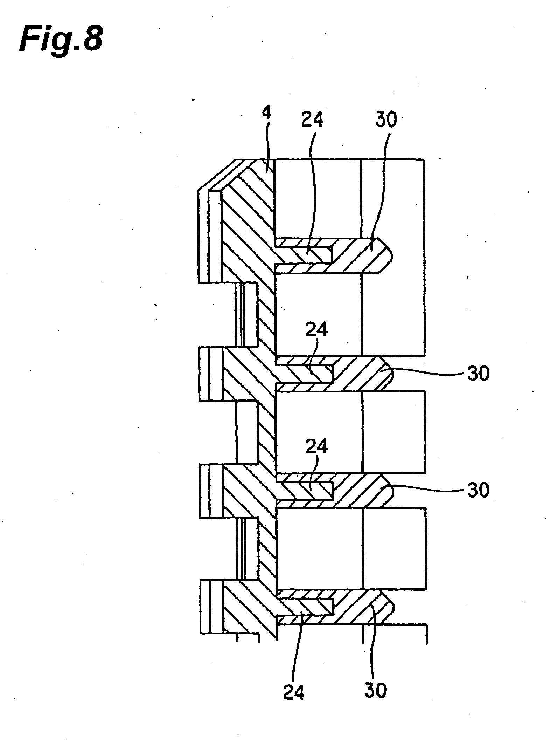

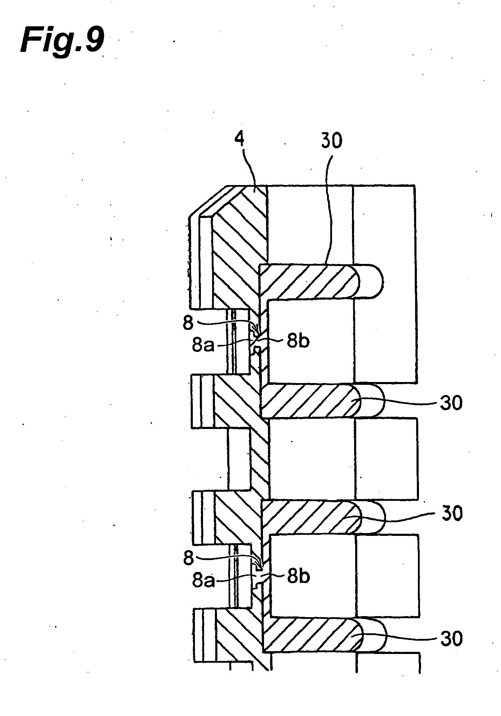

As shown in Figs. 3 through 5, 8 and 9, the plurality of second supporting parts 24 are lined up at a specified pitch in the vertical direction on the inside surfaces of the respective side walls 4 that form a part of the container main body 1. The second supporting parts 24 are arranged in a position closer to the back wall 1B of the container main body 1, and support the peripheral edges of the side parts of the substrates W in a horizontal attitude via the resin layers 30. Each second supporting part 24 is covered with the resin layer 30 and is formed in a substantially flat shape as seen in a sectional view (See Figs. 8 and 9). The second supporting parts 24 comprise thin supporting regions 21A which protrude toward the inside of the container main body 1 from the inside surface of the side wall 4, and each thin region 21A supports the peripheral edge of the side part of the substrate W in a horizontal attitude via the resin layer 30. In this embodiment, the "thin" region 21A mean that the thin region 21A is thinner than the thick region of the first supporting part 20. The upper surface of each thin region 21A is formed in a position corresponding to the upper surface of one of the thin regions 21 of the first supporting part 20 in the vertical direction. Further, each second supporting part 24 is formed in a substantially trapezoidal shape as seen in a plan view.

The resin layers 30 are formed by a two-color molding method using a material having a lower frictional property and a higher wear-resistant property than those of the material of the container main body 1. Specifically, a polybutylene terephthalate (PBT) or polyether ether ketone (PEEK) is used as a material for the resin layers 30. When the coefficient of friction of the resin layers 30 with respect to steel is measured in accordance with ASTM (American Society for Testing and Material) D1894, the measured value obtained is less than 0.33, and is preferably 0.20 or less.

Such resin layers 30 function to cover the contacting portions 5 of the respective side walls 4 when the substrates W having a poor slipping property contacts with the contacting portions 5. Further, as mentioned above, the resin layers 30 also function to cover the front and back surfaces of the first supporting parts 20 and the front and back surfaces of the second supporting parts 24. In cases where the substrates W are supported by the first and second supporting parts 20 and 24 on the pair of side walls 4, as shown in Figs. 3 through 5, an example of the contacting portions 5 of the respective side walls 4 is a plurality of inside surface portions 6 positioned on the extension lines EL of the intersecting center lines perpendicular to center lines CL parallel to the direction of inserting and removing the substrates W among the center lines passing on the substrates W when the substrate are supported on the first supporting parts 20 and the second supporting parts 24. Further, another example of the contacting portions 5 is the bent rear part inside surfaces 7 of the respective side walls 4 (See Fig. 3).

In cases where the container main body 1 is manufactured as described above, the mold for the side walls 4 is first filled with a material such as a polycarbonate or the like, and the respective side walls 4, the first supporting parts 20 and the second supporting parts 24 are integrally formed. At the same time, the contacting portions 5 for contacting with the peripheral edge part of the substrate is formed on the side wall of the container main body 1 in accordance with the shape of the mold for the side walls 4.

Further, the mold is filled with a resin having a lower frictional property and a higher wear-resistant property. Then the resin layers 30 covers the first supporting parts 20, the second supporting parts 24 and the contacting portions 5 of the respective side walls 4 that are to be contacted with the peripheral edge parts of the substrates W. Accordingly, the contacting portions 5, the first supporting parts 20 and the second supporting parts 24 are covered by the resin layers 30 and integrated with the resin layers 30.

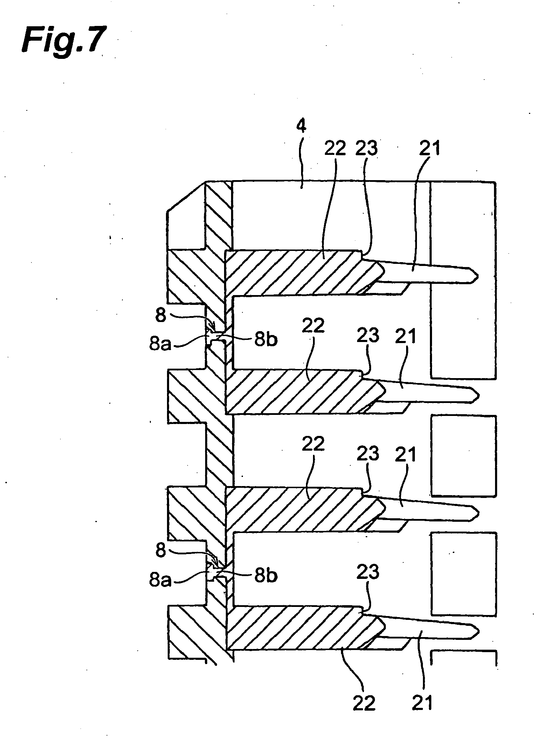

When molding the resin layers 30, the mold is filled with the resin having a lower frictional property and a higher wear-resistant property from the side of the outsides of the side walls 4. As shown in Figs. 7 and 9, it is desirable that the resin layers 30 include flanges 8 formed in the side walls 4. In this case, the resin for forming the resin layers 30 are filled from the outsides of the respective side walls 4 via through holes having the shape corresponding to the flanges 8. Each flange 8 has an outer portion 8a near an outside surface of the side wall 4 and an inner portion 8b near an inside surface of the side wall 4, and the outer portion 8a has a larger dimension than that of the inner portion 8b (See Figs. 7 and 9). Owing to these flanges 8, the covering portions (that is, the resin layers 30) do not slip out. Specifically, if the flanges 8 with large dimensions are formed beforehand, then peeling or positional deviation of the covering resin layers 30 can be suppressed or prevented even in cases where the adhesive strength of the interface between the resin of the side walls 4 and the resin of the resin layers 30 is small so that a sufficient adhesive strength cannot be expected.

In the case of providing the flanges 8, the side walls 4 are formed with a through hole having a shape corresponding to the flanges 8 having the larger dimension on an outside surface of the side wall compared with the dimension on an inside surface of the side wall. Then the mold is filled with the resin for forming the resin layers 30 from the outsides of the side wall via the through hole

After the contacting portions 5 of the respective side walls 4 and the first and second supporting parts 20 and 24 have thus been covered by the resin layers 30, the pair of side walls 4 are inserted into the mold for the container main body 1. Then, a resin such as a polycarbonate or the like is injected into the mold and cooled and hardened, and a container main body 1 with side walls 4 integrated on both sides can be manufactured.

In the abovementioned construction, most of the container main body 1 that contacts the substrates W is covered by resin layers 30 which are elements independent from the container main body 1, so that the slipping characteristics against substrates W are improved. Accordingly, even if the substrate storage container is subjected to shocks, it is possible to prevent damage to the substrates W, which is caused by the rubbing of the peripheral edge parts or back surfaces of the substrates W and the first and second supporting parts 20 and 24. As a result, it is possible to conspicuously suppress or prevent a drop in the function and yield of the product.

Further, the yield can be improved by narrowing the exclusion region from the circumferential edge parts of the substrates W (for example, 3 mm in the inward radial direction). Further, since the conventional supporting parts having a shape bent along a peripheral edge of the substrate are divided into the first and second supporting parts 20 and 24 and caused to protrude separately, a clearance 25 is formed between the first and second supporting parts 20 and 24. Accordingly, the contact area with the substrates W can be surely reduced, so that contamination by organic matter can be greatly reduced.

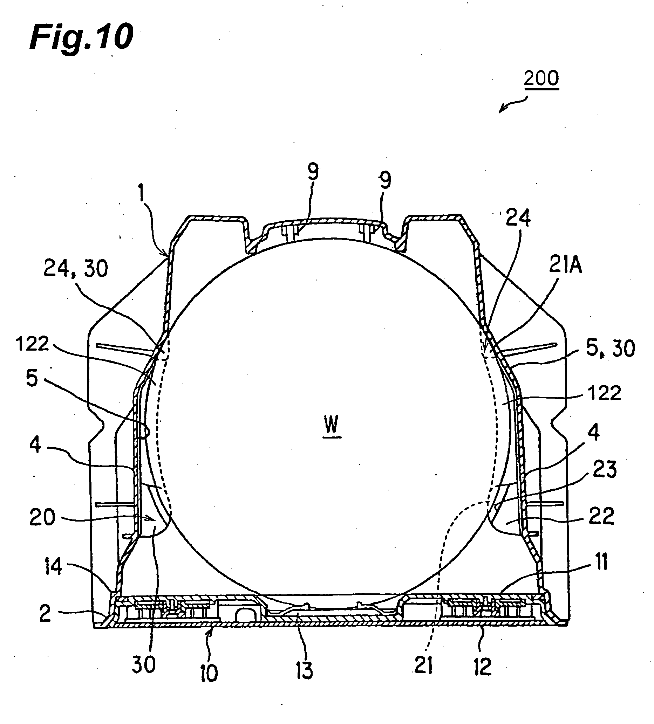

Next, Fig. 10 shows a substrate storage container 200 as a second embodiment according to the present invention. In this case, a pair of left and right elastic rear retainers 9 support the peripheral edge part of the substrates W at the rear parts and are disposed on the back wall 1B (specifically, mounted on the inside surface of the back wall 1B) which is the inside wall of the container main body 1. In the substrate storage container 200, the first and second supporting parts 20, 24 are connected by intermediate parts 122. Accordingly, each set of the first and second supporting parts 20 and 24 are formed as a continuous integral body rather than being formed separately. The intermediate parts 122 connecting the first and second supporting parts 20 and 24 have a planar arc shape on their edges, and thicknesses of the intermediate parts 122 are smaller than those of the first and second supporting parts 20 and 24. Therefore, the intermediate parts 122 are apart from the inserted substrates W in the vertical direction and are shaped not to contact with the back surface peripheral edge parts of the substrates W. Accordingly, even if the substrate storage container is subjected to shocks, it is possible to prevent damage to the substrates W as well as the case of the first embodiment.

A plurality of pairs of the elastic rear retainers 9 are lined up in the vertical direction. The respective rear retainers 9 are superior in terms of elasticity, wear resistance and low frictional property, and are formed to have a substantially U-shaped or V-shaped cross section. The rear retainers 9 are formed with a material having less danger of contaminating the substrates W, e.g., a polybutylene terephthalate, polyether ether ketone, polyester type elastomer, polyolefin type elastomer or the like.

Each of the first supporting parts 20 has a thin region 21 and a thick region 22 as the first supporting parts 20 according to the first embodiment have. The thin region 21 protrudes toward the inside of the container main body 1 from the inside surface of the corresponding side wall 4, and supports the peripheral edges of the side parts of the substrates W in a horizontal attitude via the resin layer 30. The thick region 22 is formed on the outer side of the thin region 21, and prevents the substrates W from jumping out or moving. Bumps 23 corresponding to the thickness of the substrate W are formed between the thin region 21 and thick region 22. The remaining parts are the same as in the above-mentioned first embodiment; therefore, a description of these parts is omitted here.

Actions and effects that are substantially similar to those of the first embodiment can also be expected in this second embodiment. Further, since the respective substrates W are clamped and protected in the front and rear directions and rear retainers 9 by the front retainers 13 that have a shock-absorbing effect, it is clear that even if the substrate storage container is subjected to shocks during transport, there is no rattling of the substrates W, and the substrates W can be held in a stable manner.

Further, in the above-mentioned embodiments, the lid member 10 includes the locking mechanism to be operated from the outside via the through operating holes 42.. However, the present invention is not limited to this. For example, instead of or in addition to the locking mechanism, an anchoring mechanism may be disposed on the side portions of the lid member 10 in order to be engaged with the anchoring blocks 41 protruding from the front portions of side walls 4 of the container main body 1. Specifically, the anchoring mechanism includes partially hollow anchoring pieces respectively supported on both side portions of the lid member 10 so that the anchoring pieces can rotate around the axes on the side portions of the lid member 10 and engage in a detachable manner with the anchoring blocks 41 of the container main body 1. This kind of anchoring mechanism is disclosed, for example, in Japanese Patent Application Laid-Open No. 2004-111830. Further, in cases where the substrates W are supported by the first and second supporting parts 20 and 24 on the pair of side walls 4, the contacting portions 5 of the respective side walls 4 in order to contact with the substrates W may also be parts other than the inside surface portions 6 positioned on the extension line EL of the intersecting center line perpendicular to the center line CL parallel to the direction of inserting and removing the substrate W among the center lines passing on the substrate W. For example, the contacting portions 5 may be the plurality of bent rear part inside surfaces 7 of the respective side walls 4.

Further, the bent rear part inside surfaces 7 of the respective side walls 4 and the second supporting parts 24 may also be covered by the continuous resin layers 30, or may be covered by layers independently covering the respective side walls 4 and the second supporting parts 24. Further, the thin regions 21, the thick regions 22 and the bumps 23 may also be shaped not by the resin layers 30, but by the original shape of the first supporting parts 20 to be covered with the resin layers 30. Further, the side walls 4 including first and second supporting parts 20 and 24 may be integrally molded by being inserted into a mold for the container main body 1.

Moreover, the side walls 4 and container main body 1 may also be integrally formed by laser welding, thermal fusion or ultrasonic fusion. In this case, integration may be achieved by interposing a sealing member such as packing or the like between the respective side walls 4 and the remaining parts of the container main body 1. Further, the sealing member may be integrated beforehand with the side walls 4 or container main body 1, or may be formed as a separate member.

The present invention has the effect of being able to suppress the scratching of the substrates W and the generation of dust due to rubbing between the substrates W and supporting parts. Further, the present invention also has the effect of being able to suppress the contamination and scratching of the circumferential edge parts and back surfaces of the substrates.

Further, if an elastic retainers 9, 13 that support the peripheral edge parts of the substrates W are disposed on the inside surface of the container main body, looseness of the substrates W can be suppressed even if the substrate storage container 200 is subjected to shocks during movement.

Further, if the first and second supporting parts 20 and 24 are respectively caused to protrude separately from both side walls of the container main body, and if a clearance 25 is formed between these first and second supporting parts 20 and 24, the amount of material used in the first and second supporting parts 20 and 24 can be reduced. Further, since the contact areas with the substrates can be reduced, contamination accompanied by the contact can be reduced.

Here, substrates applicable for the present invention include various types of single or multiple semiconductor wafers (e.g., 200 mm, 300 mm or 450 mm types), liquid crystal glasses, photo-mask glasses and precision substrates such as aluminum discs or the like. The container main body 1 may be front-open box type, top-open box type, FOSB type or FOUB type, and may be transparent, opaque, or semi-transparent, and conductive or insulating.

## Claims

1. A substrate storage container comprising:
a container main body (1) made of resin and including an opening portion (1F), a back wall (1B), a pair of side walls (4) and bent rear part inside surfaces (7) respectively between the back wall (1B) and one of the side walls (4);
a lid member (10) closing the opening portion (1F) of the container main body (1); and
first supporting parts (20) protrudingly and opposingly disposed on each side wall (4) in order to support a peripheral edge part of a substrate (W);
**characterised in that**
the substrate storage container further comprises:
second supporting parts (24) protrudingly and opposingly disposed on each side wall (4), configured to support the peripheral edge part of the substrate (W) and positioned between the back wall (1B) and the first supporting parts (20),
the first supporting parts (20), the second supporting parts (24) or the bent rear part inside surfaces (7) are respectively covered with a resin layer (30) having a lower frictional property than that of the container main body (1), and
wherein each first supporting part (20) includes
a first region (21) supporting the peripheral edge part of the substrate (W) via the resin layer (30) and
a second region (22) formed on an outer side of the first region (21) the first region (21) being thinner than the second region (22) to define bumps (23), and
wherein each second supporting part (24) includes
a supporting region (21A) supporting the peripheral edge of the substrate (W) via the resin layer (30), the supporting region (21A) being thinner than the second region (22) of the first supporting part (20), and
wherein the first regions (21) of the first supporting parts (20) and the supporting regions (21A) of the second supporting parts (24) are disposed in order to support the substrate (W) in a horizontal attitude; and
wherein the side wall (4) of the container main body (1) further comprises a contacting portion (5) in order to contact with the peripheral edge part of the substrate (W),
wherein the contacting portion (5) is positioned on an extension line (EL) of an intersecting center line perpendicular to a center line (CL) parallel to a direction of inserting and removing the substrate (W) among the center lines passing on the substrate (W) when the substrate (W) is supported on the first supporting part (20) and the second supporting part (24), and
wherein the contacting portion (5) is covered with the resin layer (30).

2. A substrate storage container according to Claim 1, further comprising:
an elastic retainer (9) supporting the peripheral edge part of the substrate (W) and disposed on the back wall (1B) of the container main body (1).

3. A substrate storage container according to Claim 1,
wherein the first supporting parts (20) and second supporting parts (24) are respectively protruded from the side walls (4) of the container main body (1), and a clearance (25) is formed between the first supporting part (20) and the second supporting part (24) on each side wall (4).

4. A substrate storage container according to Claim 1,
wherein the container main body (1) is made of a material including one of polycarbonate, polybutylene terephthalate, cycloolefin polymer, polyether imide, polyether ether ketone and alloy resin, and
wherein the resin layer (30) is made of one of polybutylene terephthalate and polyether ether ketone.

5. A substrate storage container according to Claim 1,
wherein the resin layer (30) includes a flange (8) formed inside the side wall (4) and having an outer portion (8a) near an outside surface of the side wall (4) and an inner portion (8b) near an inside surface of the side wall (4), and
wherein the outer portion (8a) has a larger dimension than that of the inner portion.

6. A method for manufacturing a substrate storage container including a container main body (1) made of resin and having an opening portion (1F), a back wall (1B), a pair of side walls (4) and bent rear part inside surfaces (7) respectively between the back wall (1B) and one of the side walls (4), first supporting parts (20) protrudingly and opposingly disposed on each side wall in order to support a peripheral edge part of a substrate (W), and second supporting parts (24) protrudingly and opposingly disposed on each side wall (4) in order to support the peripheral edge part of the substrate (W) and positioned between the back wall (1B) and the first supporting parts (20), said method comprising:
forming the first supporting parts (20) and the second supporting parts (24) so as to protrude inward from the side walls (4) of the container main body (1);
covering the first supporting parts (20), the second supporting parts (24) or the bent rear part inside surfaces (7) with a resin layer having a lower frictional property than that of the container main body,
covering a contacting portion (5) with the resin layer (30) for contacting with the peripheral edge part of the substrate (W) on the side wall (4) of the container main body (1); and
forming the container main body (1) by inserting the side walls (4) in a mold for forming the back wall (1B) of the container main body (1),
wherein each first supporting part (20) includes
a first region (21) supporting the peripheral edge part of the substrate (W) via the resin layer (30) and
a second region (22) formed on an outer side of the thin region (21), the first region (21) being thinner than the second region (22) to define bumps (23) for preventing the substrate (W) from moving, and
wherein each second supporting part (24) includes
a supporting region (21A) supporting the peripheral edge of the substrate (W) via the resin layer (30), the supporting region (21 A) being thinner than the second region (22) of the first supporting part (20), and
wherein the first regions (21) of the first supporting parts (20) and the supporting regions (21A) of the second supporting parts (24) are disposed in order to support the substrate (W) in a horizontal attitude.

7. A method for manufacturing a substrate storage container according to Claim 6, further comprising:
forming the side wall (4) with a through hole having a shape corresponding to a flange (8) having an outer portion (8a) near an outside surface of the side wall (4) and an inner portion (8b) near an inside surface of the side wall (4) wherein the outer portion (8a) of the flange (8) has a larger dimension than that of the inner portion (8b); and
filling the resin for forming the resin layers (30) from the outsides of the side wall (4) via the through hole.

## Patentansprüche

1. Substrat-Lagerungsbehälter, umfassend:
einen Behälter-Hauptkörper (1) aus Harz mit einem Öffnungsabschnitt (1F), einer Rückwand (1B), einem Paar Seitenwände (4) und gebogenen Rückteil-Innenflächen (7), die sich jeweils zwischen der Rückwand (1B) und einer der Seitenwände (4) befinden;
ein Deckelelement (10), das den Öffnungsabschnitt (1F) des Behälter-Hauptkörpers (1) verschließt; und
erste Trageteile (20), die vorspringend und gegenüberliegend an jeder Seitenwand (4) angebracht sind, so dass sie einen Umfangsrandteil eines Substrats (W) tragen;
**dadurch gekennzeichnet, dass**
der Substrat-Lagerungsbehälter zudem umfasst:
zweite Trageteile (24), die vorspringend und gegenüberliegend an jeder Seitenwand (4) angebracht und derart gebaut sind, dass sie den Umfangsrandteil eines Substrats (W) tragen, und zwischen der Rückwand (1 B) und den ersten Trageteilen (20) positioniert sind,
wobei die ersten Trageteile (20), die zweiten Trageteile (24) oder die gebogenen Rückteil-Innenflächen (7) jeweils mit einer Harzschicht (30) bedeckt sind, deren Reibungseigenschaft kleiner ist als diejenige des Behälter-Hauptkörpers (1), und
wobei jeder erste Trageteil (20) enthält:
einen ersten Bereich (21), der den Umfangsrandteil des Substrats (W) mittels der Harzschicht (30) trägt und
einen zweiten, auf einer Außenseite des ersten Bereichs (21) hergestellten Bereich (22), wobei der erste Bereich (21) dünner ist als der zweite Bereich (22), so dass Höcker (23) hergestellt werden, und
wobei jeder zweite Trageteil (24) enthält:
einen Tragebereich (21A), der den Umfangsrand des Substrats (W) mittels der Harzschicht (30) trägt, wobei der Tragebereich (21A) dünner ist als der zweite Bereich (22) des ersten Trageteils (20), und
wobei die ersten Bereiche (21) der ersten Trageteile (20) und die Tragebereiche (21A) der zweiten Trageteile (24) so angebracht sind, dass sie das Substrat (W) in horizontaler Lage halten; und
wobei die Seitenwand (4) des Behälter-Hauptkörpers (1) zudem einen Kontaktabschnitt (5) umfasst, so dass sie mit dem Umfangsrandteil des Substrats (W) in Kontakt tritt,
wobei der Kontaktabschnitt (5) sich auf einer Verlängerungslinie (EL) einer Mittellinie befindet, die eine Mittellinie (CL), die parallel ist zu einer Richtung zum Einsetzen und Entnehmen des Substrats (W), unter den Mittellinien, die auf das Substrat (W) weiter verlaufen, senkrecht schneidet, wenn das Substrat (W) auf dem ersten Trageteil (20) und dem zweiten Trageteil (24) getragen wird, und
wobei der Kontaktabschnitt (5) mit der Harzschicht (30) bedeckt ist.

2. Substrat-Lagerungsbehälter nach Anspruch 1, der zudem umfasst:
eine elastische Halterung (9), die den Umfangsrandteil des Substrats (W) hält und an der Rückwand (1 B) des Behälter-Hauptkörpers (1) angebracht ist.

3. Substrat-Lagerungsbehälter nach Anspruch 1, wobei die ersten Trageteile (20) und die zweiten Trageteile (24) jeweils von den Seitenwänden (4) des Behälter-Hauptkörpers (1) vorspringen und ein freier Raum (25) zwischen dem ersten Trageteil (20) und dem zweiten Trageteil (24) an jeder Seitenwand (4) gebildet wird.

4. Substrat-Lagerungsbehälter nach Anspruch 1, wobei der Behälter-Hauptkörper (1) aus Material hergestellt ist, das eines aus Polycarbonat, Polybutylen-terephthalat, Cycloolefin-Polymer, Polyetherimid, Polyetheretherketon und Legierungsharz umfasst, und
wobei die Harzschicht (30) aus einem Material aus Polybutylenterephthalat und Polyetheretherketon hergestellt ist.

5. Substrat-Lagerungsbehälter nach Anspruch 1, wobei die Harzschicht (30) einen Flansch (8) im Inneren der Seitenwand (4) enthält mit einem äußeren Abschnitt (8a) nahe einer Außenfläche der Seitenwand (4) und einem inneren Abschnitt (8b) nahe einer Innenfläche der Seitenwand (4), und
wobei der äußere Abschnitt (8a) eine größere Ausdehnung hat als der innere Abschnitt (8b).

6. Verfahren zur Herstellung eines Substrat-Lagerungsbehälters mit einem Behälter-Hauptkörper (1) aus Harz und mit einem Öffnungsabschnitt (1 F), einer Rückwand (1B), einem Paar Seitenwände (4) und gebogenen Rückteil-Innenflächen (7), die sich jeweils zwischen der Rückwand (1 B) und einer der Seitenwände (4) befinden, ersten Trageteilen (20), die vorspringend und gegenüberliegend an jeder Seitenwand angebracht sind, so dass sie einen Umfangsrandteil eines Substrats (W) tragen, und zweiten Trageteilen (24), die vorspringend und gegenüberliegend an jeder Seitenwand (4) angebracht sind, so dass sie den Umfangsrandteil des Substrats (W) tragen, und zwischen der Rückwand (1B) und den ersten Trageteilen (20) positioniert sind, wobei das Verfahren folgendes umfasst:
Formen der ersten Trageteile (20) und der zweiten Trageteile (24), so dass sie von den Seitenwänden (4) des Behälter-Hauptkörpers (1) vorspringen;
Bedecken der ersten Trageteile (20), der zweiten Trageteile (24) und der gebogenen Rückteil-Innenflächen (7) mit einer Harzschicht, deren Reibungseigenschaft kleiner ist als diejenige des Behälter-Hauptkörpers (1),
Bedecken eines Kontaktabschnitts (5) mit der Harzschicht (30) für einen Kontakt mit dem Umfangsrandteil des Substrats (W) an der Seitenwand (4) des Behälter-Hauptkörpers (1); und
Formen des Behälter-Hauptkörpers (1) durch Einbringen der Seitenwände (4) in eine Form zum Formen der Rückwand (1 B) des Behälter-Hauptkörpers (1),
wobei jeder erste Trageteil (20) enthält:
einen ersten Bereich (21), der den Umfangsrandteil des Substrats (W) mittels der Harzschicht (30) trägt, und
einen zweiten Bereich (22), der auf einer Außenseite des dünnen Bereichs (21) hergestellt wird, wobei der erste Bereich (21) dünner ist als der zweite Bereich (22), so dass Höcker (23) erzeugt werden, die verhindern, dass sich das Substrat (W) bewegt, und
wobei jeder zweite Trageteil (24) enthält:
einen Tragebereich (21A), der den Umfangsrand des Substrats (W) mittels dere Harzschicht (30) trägt, wobei der Tragebereich (21A) dünner ist als der zweite Bereich (22) des ersten Trageteils (20), und
wobei die ersten Bereiche (21) der ersten Trageteile (20) und die Tragebereiche (21A) der zweiten Trageteile (24) so angebracht sind, dass sie das Substrat (W) in horizontaler Lage halten.

7. Verfahren zur Herstellung eines Substrat-Lagerungsbehälters nach Anspruch 6, das zudem umfasst:
Formen der Seitenwand (4) mit einem Durchgangsloch, dessen Form einem Flansch (8) entspricht mit einem äußeren Abschnitt (8a) nahe einer Außenfläche der Seitenwand (4) und einem inneren Abschnitt (8b) nahe einer Innenfläche der Seitenwand (4), wobei der äußere Abschnitt (8a) des Flansches (8) eine größere Ausdehnung hat als der innere Abschnitt (8b); und
Füllen des Harzes zum Formen der Harzschichten (30) von den Außenseiten der Seitenwand (4) durch das Durchgangsloch.

## Revendications

1. Conteneur de stockage de substrat comprenant :
- un corps principal de conteneur (1) fait de résine et comportant une partie d'ouverture (1F), une paroi arrière (1B), une paire de parois latérales (4) et des surfaces intérieures de partie arrière inclinées (7) respectivement entre la paroi arrière (1B) et une des parois latérales (4) ;
- un organe formant couvercle (10) fermant la partie d'ouverture (1F) du corps principal de conteneur (1) ; et
- des premières pièces de support (20) disposées en saillie et en opposition sur chaque paroi latérale (4) afin de soutenir une partie de bord périphérique d'un substrat (W) ;
- **caractérisé en ce que :**
- le conteneur de stockage de substrat comprend, en outre
- des secondes pièces de support (24) disposées en saillie et en opposition sur chaque paroi latérale (4), conformées pour soutenir la partie de bord périphérique du substrat (W) et positionnées entre la paroi arrière (1B) et les premières pièces de support (20) ;
- les premières pièces de support (20), les secondes pièces de support (24) ou les surfaces intérieures de partie arrière inclinées (7) sont respectivement recouvertes d'une couche de résine (30) ayant des propriétés de moindre friction que celle du corps principal de conteneur (1) ;
- dans lequel chaque première pièce de support (20) comporte
- une première région (21) soutenant la partie de bord périphérique du substrat (W) par l'intermédiaire de la couche de résine (30) et
- une seconde région (22) formée sur un côté extérieur de la première région (21), la première région (21) étant plus mince que la seconde région (22) pour définir des bossages (23) ;
- dans lequel chaque seconde pièce de support (24) comporte
- une région portante (21 A) soutenant le bord périphérique du substrat (W) par l'intermédiaire de la couche de résine (30), la région portante (21 A) étant plus mince que la seconde région (22) des premières pièces de support (20) ;
- dans lequel les premières régions (21) des premières pièces de support (20) et les régions portantes (21A) des secondes pièces de support (24) sont disposées pour soutenir le substrat (W) dans une orientation horizontale ;
- dans lequel la paroi latérale (4) du corps principal de conteneur (1) comporte, en outre, une partie de contact (5) pour venir au contact de la partie de bord périphérique du substrat (W) ;
- dans lequel la partie de contact (5) est positionnée sur une ligne d'extension (EL) d'une ligne centrale d'intersection perpendiculaire à une ligne centrale (CL) parallèle à une direction d'insertion et de retrait du substrat (W) parmi les lignes centrales passant sur le substrat (W) lorsque le substrat (W) est soutenu sur la première pièce de support (20) et la seconde pièce de support (24) ; et
- dans lequel la partie de contact (5) est recouverte de la couche de résine (30).

2. Conteneur de stockage de substrat selon la revendication 1, comprenant, en outre :
- un dispositif élastique de retenue (9) soutenant la partie de bord périphérique du substrat (W) et disposé sur la paroi arrière (1B) du corps principal de conteneur (1).

3. Conteneur de stockage de substrat selon la revendication 1,
- dans lequel les premières pièces de support (20) et les secondes pièces de support (24) font respectivement saillie depuis les parois latérales (4) du corps principal de conteneur (1) et un espace libre (25) est ménagé entre la première pièce de support (20) et la seconde pièce de support (24) sur chaque paroi latérale (4).

4. Conteneur de stockage de substrat selon la revendication 1,
- dans lequel le corps principal de conteneur (1) est fait d'un matériau comprenant un matériau parmi un polycarbonate, un polybutylène téréphtalate, un polymère de cyclooléfine, un polyéther imide, un polyéther éther kétone et des résines alliées et
- dans lequel la couche de résine (30) est faite d'un matériau parmi un polybutylène téréphtalate et un polyéther éther kétone.

5. Conteneur de stockage de substrat selon la revendication 1,
- dans lequel la couche de résine (30) comprend un rebord (8) formé à l'intérieur de la paroi latérale (4) et ayant une partie extérieure (8a) proche d'une surface extérieure de la paroi latérale (4) et une partie intérieure (8b) proche d'une surface intérieure de la paroi latérale (4) et
- dans lequel la partie extérieure (8a) a une plus grande dimension que celle de la partie intérieure.

6. Procédé de fabrication d'un conteneur de stockage de substrat comprenant un corps principal de conteneur (1) fait de résine et ayant une partie d'ouverture (1F), une paroi arrière (1B), une paire de parois latérales (4) et des surfaces intérieures de partie arrière inclinées (7) respectivement entre la paroi arrière (1B) et une des parois latérales (4), des premières pièces de support (20) disposées en saillie et en opposition sur chaque paroi latérale afin de soutenir une partie de bord périphérique d'un substrat (W) et des secondes pièces de support (24) disposées en saillie et en opposition sur chaque paroi latérale (4) afin de soutenir la partie de bord périphérique du substrat (W) et positionnées entre la paroi arrière (1B) et les premières pièces de support (20), ledit procédé comprenant les étapes consistant à :
- former les premières pièces de support (20) et les secondes pièces de support (24) de manière à ce qu'elles fassent saillies vers l'intérieur depuis les parois latérales (4) du corps principal de conteneur (1) ;
- recouvrir les premières pièces de support (20), les secondes pièces de support (24) ou les surfaces intérieures de partie arrière inclinées (7) d'une couche de résine ayant des propriétés de moindre friction que celle du corps principal de conteneur ;
- recouvrir une partie de contact (5) de la couche de résine (30) pour venir au contact de la partie de bord périphérique du substrat (W) sur la paroi latérale (4) du corps principal de conteneur (1) ; et
- former le corps principal de conteneur (1) en insérant les parois latérales (4) dans un moule pour former la paroi arrière (1B) du corps principal de conteneur (1) ;
- pour lequel chaque première pièce de support (20) comporte :
- une première région (21) soutenant la partie de bord périphérique du substrat (W) par l'intermédiaire de la couche de résine (30) et
- une seconde région (22) formée sur un côté extérieur de la région mince (21), la première région (21) étant plus mince que la seconde région (22) pour définir des bossages (23) afin d'empêcher le substrat (W) de se déplacer ;
- pour lequel chaque seconde pièce de support (24) comporte :
- une région portante (21 A) soutenant le bord périphérique du substrat (W) par l'intermédiaire de la couche de résine (30), la région portante (21 A) étant plus mince que la seconde région (22) des premières pièces de support (20) ; et
- pour lequel les premières régions (21) des premières pièces de support (20) et les régions portantes (21A) des secondes pièces de support (24) sont disposées pour soutenir le substrat (W) dans une orientation horizontale.

7. Procédé de fabrication d'un conteneur de stockage de substrat selon la revendication 6, comprenant, en outre, les étapes consistant à :
- former la paroi latérale (4) avec un trou traversant ayant une forme correspondant à un rebord (8) ayant une partie extérieure (8a) proche d'une surface extérieure de la paroi latérale (4) et une partie intérieure (8b) proche d'une surface intérieure de la paroi latérale (4), la partie extérieure (8a) du rebord (8) ayant une plus grande dimension que celle de la partie intérieure (8b) ; et
- remplir de résine pour former les couches de résine (30) depuis l'extérieur de la paroi latérale (4) par l'intermédiaire du trou traversant.
